# EUROPEAN PATENT APPLICATION

(11) **EP 4 440 287 A1**
(43) Date of publication of application: **02.10.2024**
(21) Application number: 23190983.9
(22) Date of filing: 11.08.2023
(51) Int. Cl.: H10N 10/852, H10N 10/17, H10N 10/857

(54) **THERMOELECTRIC CONVERTER BASED ON FUNCTIONALLY GRADED MATERIALS**

(30) Priority: 29.03.2023 PL 44424023
(71) Applicant: Akademia Gorniczo-Hutnicza im. Stanislawa Staszica w Krakowie, 30-059 Krakow (PL)
(72) Inventor: Wojciechowski, Krzysztof, 32-082 Wieckowice (PL); Parashchuk, Taras, 31-221 Kraków (PL); Maksymuk, Mykola, 30-065 Kraków (PL)
(74) Representative: Wlasienko, Jozef

(57) **Abstract**

The subject matter of the invention is a thermoelectric converter made of thermoelectric materials based on bismuth telluride, including:
- n-type andp-type thermoelectric elements,
- made of metal anti-diffusion layers on the top and bottom surface of the thermoelectric elements,
- metal electrodes being in contact with the anti-diffusion layers and dielectric substrates having a high thermal conductivity,
- the mentioned dielectric substrates having a high thermal conductivity, wherein
the mentioned thermoelectric elements are electrically connected in series by the mentioned electrodes forming thermoelectric unicouples, located between the substrates having a high thermal conductivity, and wherein
- a negative terminal is connected to the n-type thermoelectric element of the first thermoelectric unicouple and a positive terminal is connected to the p-type thermoelectric element of the second thermoelectric unicouple, which terminals serve for the output of the generated electric power, characterized by that the n-type (1) and *p*-type (2) thermoelectric elements based on the bismuth telluride alloys contain dopants having a diversified chemical composition, respectively: Se, halogen or its mixtures along the *n*-type thermoelectric elements and Sb along the *p*-type thermoelectric elements and form a graded structure.

## Description

### Field of the invention

The subject matter of the invention is a thermoelectric converter based on functionally graded materials. In particular, the invention includes the thermoelectric converter made of thermoelectric materials based on bismuth telluride.

The thermoelectric converter can be used for the construction of devices that convert heat directly into electric current (thermoelectric generators), as well as for the construction of thermoelectric heat pumps (Peltier modules) for heating and cooling purposes.

### Background of the invention

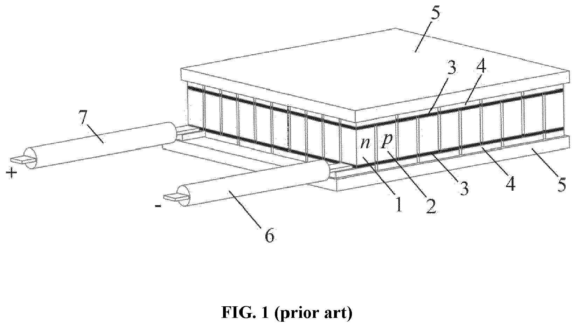

A known construction of a typical thermoelectric converter (or module) is presented in Fig. 1. The indicated thermoelectric converter consists of thermoelectric elements (thermoelectric legs) containing semiconductor elements (1) and (2) having a *n*-type and a *p*-type electrical conductivity, respectively. Each thermoelectric element on the top and the bottom surface is covered with anti-diffusion layers (3), which prevent chemical diffusion between the semiconductor materials of the thermoelectric elements and the electrode material (4) and ensure electrical contact between the thermoelectric elements and the electrodes (4). The *n* and *p* thermoelectric elements alternately are electrically connected in series by metal electrodes (4) thus forming a series of thermoelectric unicouples, which are located between two substrates made of dielectric materials having a high thermal conductivity (5). Two terminals (6,7) serving for the output of the generated electric power are connected to the thermoelectric unicouples by electrodes (4), in particular a negative terminal (6) is connected to the *n*-type element of the first thermoelectric unicouple, while a positive terminal (7) is connected to the *p*-type element of the last thermoelectric unicouple.

The principle of the operation of the thermoelectric converter is based on the usage of the Seebeck effect in which the temperature difference generated at the ends of the thermoelectric unicouple leads to the generation of an electromotive force. Connecting an electrical load to the thermoelectric converter and closing the electrical circuit causes the flow of an electrical current.

Typical currently produced commercial converters based on the bismuth telluride (Bi₂Te₃) alloys consist of thermoelectric elements having a homogeneous chemical composition.

However, in the scientific and patent literature thermoelectric modules are known, in which thermoelectric elements are made of the so-called functionally graded materials (FGMs).

### State of the art description

For example, patent application US 20210313503 A1 describes a functionally graded organic thermoelectric material made of conducting polymers having a different degree of doping. The module presented in this patent application consists of *n*-type and *p*-type semiconductor elements made on the basis of organic polymers containing a molecular dopant. The distribution of the dopant along the surface of the polymer is carried out in a controlled manner, wherein in particular embodiments, the distribution has a step, linear, sigmoidal or bell curve character. The *n*-type and the *p*-type elements are placed between two substrates and are electrically connected in series by metallic electrodes, e.g. made of silver, gold, copper, nickel and their alloys.

From the patent literature there are also known descriptions of the so-called segmented thermoelectric modules, in which thermoelectric elements are composed of two or more segments made on the basis of different inorganic semiconductor materials with the same type of conductivity (*n* or *p*)*.*

From the patent specifications WO 2010071749 A1, US 2010029911 A1 and RU 2550799 C2 two constructions of the so-called segmented thermoelectric module are known which consist of *p*-type and *n*-type thermoelectric elements electrically connected in series by electrodes made of Fe on the hot side and electrodes made of Zn (or Mo and Al) on the cold side of the module. The *p*-type element is divided into the so-called low-temperature segment made of a material based on Bi₂Te₃, a medium-temperature segment based on PbTe with Na dopant and a high-temperature segment based on PbSnMnTe or PbSnTe alloys, which simultaneously serves the function of an anti-diffusion layer. Use of the high-temperature segment is intended to prevent degradation of the medium-temperature PbTe segment as a result of the diffusion between the Fe electrode and an excess of Te contained in the medium-temperature segment. Moreover, in order to improve the quality of the contact connections between the Fe electrodes and the *p*-type segmented elements, a thin SnTe layer is deposited on the top side of the high-temperature segment. The *n*-type element consists of a low-temperature segment based on Bi₂Te₃ and a high-temperature segment based on *n*-PbTe for the first variant of realization of the thermoelectric module, while the second variant contains three segments of the *n*-type element, i.e. a low-temperature segment based on Bi₂Te₃ and the medium and high-temperature regions based on PbTe containing different amounts of the iodine dopant. To prevent chemical diffusion between the Bi₂Te₃ and PbTe segments, the authors recommend the additional use of an anti-diffusion layer. The maximum efficiency of the described segmented thermoelectric module is 11% and 10% in the operating temperature range of 50-560°C for the first and the second construction, respectively.

From the patent specifications US 8921679 B2, CN 103187519 A and TW 201327952 A1 a segmented thermoelectric module is known, which consists of segmented thermoelectric elements placed on ceramic or alumina substrates. The thermoelectric elements are electrically connected in series by Fe electrodes covered with Sn layers on the hot side and Cu electrodes covered with Ni, Ag or Au on the cold side of the module. The connection between the thermoelectric elements and the electrodes is provided by a solder layer. The *p-*type element consists of a low-temperature segment based on BiₓSb₂₋ₓTe₃ (x=0.35-0.65), a medium-temperature segment based on *β*-Zn₄Sb₃, and a high-temperature segment based on Pb₁₋ₓSnₓTe (x=0-0.6). In turn, the *n*-type element includes two segments, in which a low-temperature segment is made with the use of Bi₂TeₓSe₃₋ₓ (x=0.1-0.9), while a high-temperature segment is based on PbTe₁₋ₓSeₓ (x=0-0.5). To improve the reliability of the thermoelectric module, anti-diffusion layers of Ni or Fe are used to prevent diffusion between the segments.

From the patent specification WO 2018168568 A1 a segmented thermoelectric module for generating electric power with two-segment elements based on compounds having a clathrate structure is known. The first module construction includes high-temperature segments of *n*-type and *p*-type elements based on Ba₈Ga₁₆Ge₃₀ or Ba₈Ga₁₆Si₃₀, a low-temperature segment of the *p*-type element based on Ba₈Ga₁₆Sn₃₀ and a low-temperature segment of the *n*-type element based on (K, Ba)₂₄(Ga, Sn)₁₃₆, (K, Ba)₂₄(Al, Sn)₁₃₆ or (K, Ba)₂₄(Ga, Sn, Ge)₁₃₆. The second exemplary module differs in the material used for the high-temperature segment of the *n*-type element, which is based on Ba₂₄Ga₁₅Ge₈₅, Ba₂₄In₁₆Ge₈₄ or Ba₂₄(Ga, In, Ge)₁₀₀ compounds. The segmented modules operate at the maximum temperature difference of 670°C (cold side temperature is 30°C) with the efficiency of 10% and 9% for the first and the second variants, respectively.

From the patent specification of CN 107681044 A two constructions of a thermoelectric module for generating electric power with segmented elements are known. The first example was made of CeFe_{3.9}Mn_{0.1}Sb₁₂ and Yb_{0.3}Co₄Sb₁₂ for the high-temperature segments of *p-*type and *n*-type elements, while the low-temperature segments are based on *n*-Bi_{1.9} Sb_{0.1}Te and *p*-Bi₂Te_{2.85}Se_{0.05}. In order to extend the operating temperature range, the second example of the thermoelectric module additionally contains a third segment based on half-Heusler compounds (*n*-Hf_{0.3}Zr_{0.7}NiSn and *p*-FeNb_{0.8}Ti_{0.2}Sb). The segments are connected to each other and to the high- and low-temperature electrodes by solder layers. The thermoelectric elements are placed on Al₂O₃ and AlN substrate in the case of the first and the second variants of the module, respectively. The maximum efficiency of the two-segmented module is 11.8% at the hot side temperature of 575°C and 13.2% for the three-segmented module at the hot side temperature of 725°C.

From the patent specifications US 2020152849 A1, CN 107946452 B, a segmented thermoelectric module for generating electric power with a three-segmented structure of elements is known. A low-temperature segment of the *p*-type element is manufactured from the materials based on, e.g.: *p*-Bi₂Te₃, *p*-Sb₂Se₃ and *p*-Sb₂Te₃. A medium-temperature segment of the *p*-type element is manufactured with the use of the materials based on, e.g.: *p*-PbTe, *p*-CoSb₃, *p*-Cu_{1.8}S, *p*-AgSbTe₂. A high-temperature segment of the *p*-type element is manufactured from *p*-SiGe, *p*-CoSb₃, *p*-SnSe, *p*-PbSe, *p*-Cu₂Se, *p*-BiCuSeO, *p*-Cu(In, Ga)Te₂, *p*-FeSi, CrSi₂, MnSi_{1.73}, CoSi, *p*-Cu_{1.8}S or *p*-type oxide materials. A low-temperature segment of the *n*-type element is manufactured with the use of the materials based on, e.g.: *n*-Bi₂Te₃, *n*-BiSb, *n*-Zn₄Sb₃, *n*-Mg₃Sb₂, *n*-Bi₂Se₃, *n*-Sb₂Se₃. A medium-temperature segment of the n-type element is made from the materials selected from the group including *n*-PbTe, *n*-PbS, *n*-CoSb₃, *n*-Mg₂Si, *n*-Zn₄Sb₃, *n*-InSb, *n*-AgSbTe₂, or oxide materials having the *n-*type conductivity. A high-temperature segment of the *n*-type element is manufactured from the materials based on, e.g.: *n* -SiGe, *n*-CoSb₃, *n*-SnSe, *n*-SnTe, *n*-Cu₂Se or *n*-type oxide materials. Each inter-segmented connection contains a stress-relaxation layer that compensates for the difference in the thermal expansion coefficients of the segments. The stress-relaxation layer is connected to the segments through anti-diffusion layers, which are applied to the appropriate contact surfaces of the segments. The authors of the solution resigned from the use of metallic electrodes. Thermoelectric elements are directly connected to each other thanks to the use of unusual geometry (L-type shape) of the elements.

From the patent specification of JP 2009032960 A, a segmented thermoelectric module for generating electric power, which includes *n*-type and *p*-type elements connected in series by electrodes into one electrical circuit is known. Thermoelectric elements consist of two segments, where a low-temperature segment is based on Bi-Te or Bi-Sb thermoelectric materials, and a high-temperature segment contains Mn-Si, Mg-Si, Si-Ge, Pb-Te, TAGS (GeTe-AgSbTe), Fe-Si, Zn-Sb alloys and material based on skutterudites. The construction of the thermoelectric elements assumes the use of an anti-diffusion and a stress-relaxation layer to prevent the diffusion and compensate for the difference in thermal expansion coefficients between the segments.

Currently produced thermoelectric modules based on homogeneous Bi₂Te₃ alloys are characterized by an efficiency of approximately 5%. Therefore, the aim of the solution is to significantly increase the energy conversion efficiency of the thermoelectric modules made on the basis of these alloys up to even 10%.

### Disclosure of the invention

According to the present invention, the thermoelectric converter made of thermoelectric materials based on bismuth telluride, including:
- *n*-type and *p*-type thermoelectric elements,
- made of metal anti-diffusion layers on the top and the bottom surface of the thermoelectric elements,
- metal electrodes being in contact with the anti-diffusion layers and dielectric substrates having a high thermal conductivity,
- the mentioned dielectric substrates having a high thermal conductivity, wherein
   the mentioned thermoelectric elements are electrically connected in series by the mentioned electrodes forming thermoelectric unicouples, located between the substrates having a high thermal conductivity, and wherein
- a negative terminal is connected to the *n*-type thermoelectric element of the first thermoelectric unicouple and a positive terminal is connected to the *p*-type thermoelectric element of the second thermoelectric unicouple, which terminals serve for the output of the generated electric power, is characterized by that *n*-type (1) and *p*-type (2) thermoelectric elements based on the bismuth telluride alloys contain dopants having a diversified chemical composition, respectively: Se, halogen or its mixtures, along the *n-*type thermoelectric elements and Sb along the *p*-type thermoelectric elements and form a graded (layered) structure.

Preferably, in the thermoelectric converter according to the invention each *n*-type thermoelectric element includes an *n*-type low-temperature region (*n*₁) made of a material having a chemical composition Bi₂Te_{3-x-y}SeₓX_{y}, where a content of x = 0.6±0.2, a content of y = 0.015±0.015 and a relative height *h*ₙ₁ = 0.66*h*ₙ ±0.3*h*ₙ of the total height of the *n*-type thermoelectric element (*h*ₙ) as well as a *n*-type high-temperature region (*n*₂) with a content of x = 0.3±0.2, a content of y = 0.03±0.02 and a relative height *h*ₙ₂ = 0.33*h*ₙ±0.15*h*ₙ of the total height of the *n*-type thermoelectric element (*h*ₙ), preferably X is halogen, and most preferably Cl, Br and/or I.

Preferably, in the thermoelectric converter according to the invention each *p*-type thermoelectric element includes a *p*-type low-temperature region (*p*₁) made of a material having a chemical composition Bi_{2-z}Sb_{z}Te₃, where a content of z = 1.5±0.5 and a relative height *h*ₚ₁ = 0.5*h*ₚ±0.25*h*ₚ of the total height of the *p*-type thermoelectric element (*h*ₚ) as well as a *p*-type high-temperature region (*p*₂) with a content of z = 1.8±0.15 and a relative height *h*ₚ₂ = 0.5/*h*ₚ±0.25/*h*ₚ of the total height of the *p*-type thermoelectric element (*h*ₚ).

### Benefits and effects of the invention

The new converters with graded thermoelectric elements developed according to the invention are characterized by a higher efficiency in relation to commercial thermoelectric modules made of homogeneous Bi₂Te₃ alloys.

As a result, thermoelectric generators constructed with the use of these converters will have a higher efficiency and thermoelectric heat pumps will have a higher coefficient of performance (COP).

The developed new converters with graded thermoelectric elements according to the invention, compared to the segmented thermoelectric modules known from the state of the art, having a similar efficiency, are characterized by a simpler construction, fewer components (no need to use anti-diffusion layers and relaxation layers between the segments), as well as significantly reduced thermal stresses, and thus greater durability and reliability.

### Brief description of the drawings

The subject matter of the invention is shown in the embodiment, with reference to the attached drawings, in which:
- **Fig. 1**: Scheme showing a typical construction of a known thermoelectric converter made on the basis of homogeneous thermoelectric materials;
- **Fig. 2**: Cross section through the graded structure of thermoelectric elements of a thermoelectric converter based on Bi₂Te₃ alloys according to the invention;
- **Fig. 3**: Scheme of an exemplary construction of a thermoelectric converter made of graded thermoelectric materials based on Bi₂Te₃ according to the invention.

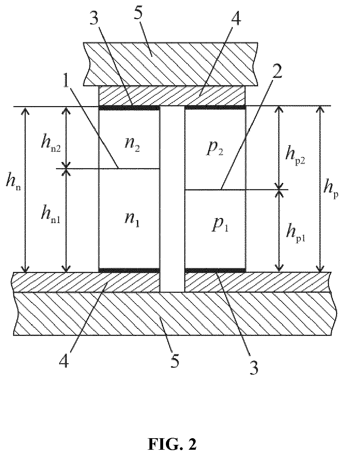

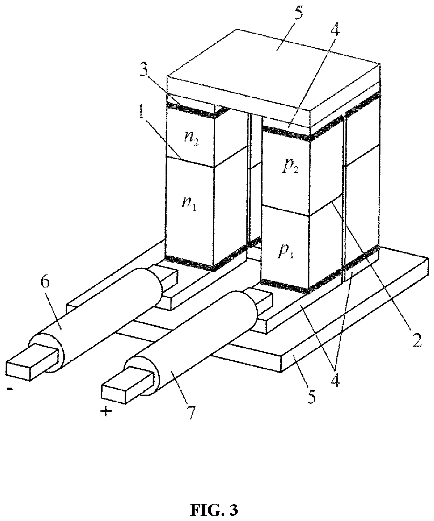

### List of reference marks to Fig. 2 and Fig. 3:

- **1**: *n*-type thermoelectric element (composed of *n*₁ and *n*₂ regions)
- **2**: *p*-type thermoelectric element (composed of *p*₁ and *p*₂ regions)
- **3**: anti-diffusion layer
- **4**: electrode
- **5**: substrate
- **6**: negative terminal
- **7**: positive terminal
- ***n*₁**: *n*-type low-temperature region
- ***n*₂**: *n*-type high-temperature region
- ***p*₁**: *p*-type low-temperature region
- ***p*₂**: *p*-type high-temperature region
- ***hₙ***: total height of the *n*-type thermoelectric element
- ***h*ₙ₁**: relative height of the *n*-type low-temperature region
- ***hₙ₂***: relative height of the *n*-type high-temperature region
- ***hₚ***: total height of the *p*-type thermoelectric element
- ***h*ₚ₁**: relative height of the *p*-type low-temperature region
- ***h*ₚ₂**: relative height of the *p*-type high-temperature region

### Detailed description of the invention

Following is the subject matter of the present invention described in detail with reference to the attached figures and embodiments. The present invention is not limited only to the specific embodiments described herein.

According to the present invention, the graded (layered) structure of the thermoelectric elements of the thermoelectric converter is made on the basis of Bi₂Te₃ alloys. The thermoelectric elements are made of Bi₂Te₃ having a different content of dopants along the thermoelectric elements, respectively: Se, halogen or its mixtures in the *n*-type material and Sb in the *p*-type material. The essence of the solution is shown in Fig. 2.

Each *n*-type thermoelectric element contains a *n*-type low-temperature region **(*n*₁)** made of a material having a chemical composition **Bi₂Te_{3-x-y}SeₓX_{y},** where a content of **x = 0.6±0.2,** a content of **y = 0.015±0.015** and a relative height ***h*ₙ₁** = **0.66*h*ₙ±0.3*h*ₙ** of the total height of the *n*-type thermoelectric element **(*h*ₙ)** as well as a *n*-type high-temperature region **(*n*₂)** with a content of **x = 0.3±0.2,** a content of **y = 0.03±0.02** and a relative height ***h*ₙ₂ = 0.33*h*ₙ±0.15*h*ₙ,** wherein X is halogen or its mixtures, most preferably Cl, Br and/or I.

Each p-type thermoelectric element contains a low-temperature *p*-type region **(*p*₁)** made of a material having a chemical composition **Bi_{2-z} Sb_{z}Te₃,** where a content of **z = 1.5±0.5** and a relative height ***h*ₚ₁** = **0.5*h*ₚ±0.25*h*ₚ** of the total height of the *p*-type thermoelectric element **(*h*ₚ)** as well as a p-type high-temperature region **(*p*₂)** with a content of **z = 1.8±0.15** and a relative height ***h*ₚ₂** = **0.5*h*ₚ±0.25*h*ₚ** for the high-temperature region of the *p*-type element.

In contrast to the segmented elements known from the state of the art, according to the present invention the thermoelectric elements are made on the basis of the same semiconductor, i.e. Bi₂Te₃.

### Embodiment

According to the invention, a construction of an exemplary thermoelectric converter made of graded thermoelectric materials based on bismuth telluride is shown in Fig. 3

The thermoelectric converter contains four thermoelectric elements (two *n*-type and **(1)** and two *p*-type **(2)**). The *n*-type element consists of a *n*-type low-temperature region **(*n*₁)** having a chemical composition **Bi₂Te_{2.385}Se_{0.6}Cl_{0.015}** and a *n*-type high-temperature region **(*n*₂)** having a chemical composition **Bi₂Te_{2.67}Se_{0.3}Cl_{0.03}.**

The *p*-element **(2)** consists of a *p*-type low-temperature region **(*p*₁)** having a chemical composition **Bi_{0.2}Sb_{1.8}Te₃** and a *p-type* high-temperature region **(*p*₂)** having a chemical composition **Bi_{0.5}Sb_{1.5}Te₃.**

Each thermoelectric element on the top and bottom surface is covered by anti-diffusion layers made of Ni **(3),** which ensure electrical contact between the thermoelectric elements and the electrodes **(4).** The thermoelectric elements are electrically connected in series by Ni electrodes **(4)** thus forming two thermoelectric unicouples which are located between two substrates of alumina Al₂O₃ **(5).** Two terminals serving for the output of the generated electric power are connected to the thermoelectric unicouples by electrodes **(4),** in particular the negative terminal **(6)** is connected to the *n*-type element of the first thermoelectric unicouple, while the positive terminal **(7)** is connected to the *p*-type element *of* the second thermoelectric unicouple.

Detailed parameters of the converter according to the invention are presented in Table 1:

**Table 1. Parameters of an examplary converter with graded thermoelectric elements.**

| Parameter | Value |
|---|---|
| Number of *n*-type thermoelectric elements | 2 |
| Number of *p*-type thermoelectric elements | 2 |
| Height of thermoelectric elements, mm | 6 mm |
| Length of thermoelectric elements, mm | 2.4 mm |
| Width of thermoelectric elements, mm | 2 mm |
| Height of the low-temperature region *n*₁ | 4 mm |
| Height of the high-temperature region *n*₂ | 2 mm |
| Height of the low-temperature region *p*₁ | 3 mm |
| Height of the high-temperature region *p*₂ | 3 mm |
| Temperature of cold side *T*_{c} | 30°C |
| Temperature of hot side *T*ₕ | 400°C |
| Open-circuit voltage *U*_{oc} | 250 mV |
| Short-circuit current *I*ₘₐₓ | 2.2 A |
| Maximum power *P*ₘₐₓ | 140 mW |
| Maximum energy efficiency ηₘₐₓ | 8.5% |

### Summary of the invention regarding the obtained results:

According to the invention, the new converters with graded thermoelectric elements are characterized by a higher efficiency and power density compared to the commercial thermoelectric modules made of homogeneous Bi₂Te₃ alloys. Compared to the segmented modules known from the state of the art, the new converters according to the invention are characterized by a simpler structure, fewer components (do not contain anti-diffusion layers and relaxation layers between the segments), as well as significantly reduced thermal stresses, and thus greater durability and reliability.

## Claims

1. A thermoelectric converter made of thermoelectric materials based on bismuth telluride, including:
- *n*-type and *p*-type thermoelectric elements,
- made of metal anti-diffusion layers on the top and bottom surface of the thermoelectric elements,
- metal electrodes being in contact with the anti-diffusion layers and dielectric substrates having a high thermal conductivity,
- the mentioned dielectric substrates having a high thermal conductivity, wherein the mentioned thermoelectric elements are electrically connected in series by the mentioned electrodes forming thermoelectric unicouples, located between the substrates having a high thermal conductivity, and wherein
- a negative terminal is connected to the *n*-type thermoelectric element of the first thermoelectric unicouple and a positive terminal is connected to the *p*-type thermoelectric element of the second thermoelectric unicouple, which terminals serve for the output of the generated electric power,
**characterized in that**
*n*-type (1) and *p*-type (2) thermoelectric elements based on the bismuth telluride alloys contain dopants having a diversified chemical composition, respectively: Se, halogen or its mixtures, along the *n*-type thermoelectric elements and Sb along the *p*-type thermoelectric elements and form a graded (layered) structure.

2. The thermoelectric converter according to claim 1, **characterized in that** each *n*-type thermoelectric element includes a *n*-type low-temperature region (*n*₁) made of a material having a chemical composition Bi₂Te_{3-x-y}SeₓX_{y}, where a content of x = 0.6±0.2, a content of y = 0.015±0.015 and a relative height *h*ₙ₁ = 0.66*h*ₙ±0.3*h*ₙ of the total height of the *n*-type thermoelectric element (*h*ₙ) as well as a *n*-type high-temperature region (*n*₂) with a content of x = 0.3±0.2, a content of y = 0.03±0.02 and a relative height *h*ₙ₂ = 0.33*h*ₙ±0.15*h*ₙ of the total height of the *n*-type thermoelectric element (*h*ₙ), preferably X is halogen, most preferably Cl, Br and/or I.

3. The thermoelectric converter according to claim 1, **characterized in that** each *p*-type thermoelectric element includes a *p*-type low-temperature region (*p*1) made of a material having a chemical composition Bi_{2-z}Sb_{z}Te₃, where a content of z = 1.5±0.5 and a relative height *h*ₚ₁ = 0.5*h*ₚ±0.25*h*ₚ of the total height of the *p*-type thermoelectric element (*h*ₚ) as well as a *p*-type high-temperature region (*p*₂) with a content of z = 1.8±0.15 and a relative height *h*ₚ₂ = 0.5*h*ₚ±0.25*h*ₚ of the total height of the *p*-type thermoelectric element (*h*ₚ)_{.}
